# DEMANDE DE BREVET EUROPEEN

(11) **EP 1 088 912 A1**
(43) Date de publication de la demande: **04.04.2001**
(21) Numéro de dépôt: 99402362.0
(22) Date de dépôt: 28.09.1999
(51) Int. Cl.: C30B 13/02, C30B 13/00, C30B 29/36, C30B 29/38, C30B 29/52

(54) **Croissance en solution dans une zone flottante de cristaux d'un composé ou d'un alliage**

(71) Demandeur: Forschungsverbund Berlin e.V., 12489 Berlin (DE); COMMISSARIAT A L'ENERGIE ATOMIQUE, 75752 Paris Cédex 15 (FR)
(72) Inventeur: Wollweber, Jürgen, 12524 Berlin (DE); Duffar, Thierry, 38000 Grenoble (FR); Santailler, Jean-Louis, 38430 Moirans (FR); Chevrier, Véronique, 33600 Pessac (FR)
(74) Mandataire: Des Termes, Monique

(57) **Abrégé**

L'invention concerne l'obtention d'un cristal d'un matériau ayant une fusion non congruente et constitué à partir d'au moins un premier élément et un deuxième élément, par exemple en :
- mettant en place en alignement vertical et maintien sous atmosphère contrôlée, un barreau de premier élément (1) enserré entre un barreau inférieur (3) et un barreau supérieur (2) constitués dudit matériau,
- transformant le barreau de premier élément (1) en zone flottante par chauffage à une température évitant l'évaporation du premier élément, le chauffage étant obtenu par des moyens de chauffage (7) réalisant un gradient de température dans la zone flottante tel que la face inférieure du barreau supérieur (2) apparaît comme un côté froid,
- mettant en contrarotation des barreaux inférieur (3) et supérieur (2) autour de l'axe d'alignement et en déplaçant l'ensemble des barreaux vers le haut par rapport aux moyens de chauffage pour obtenir sur le côté froid, par croissance en solution, ledit cristal.

## Description

### Domaine technique

La présente invention concerne la croissance en solution dans une zone flottante de cristaux d'un composé ou d'un alliage. Elle concerne en particulier la croissance de cristaux de carbure de silicium.

### Etat de la technique antérieure

Le carbure de silicium est un matériau qui est de plus en plus utilisé dans le domaine des semiconducteurs. Il peut être fabriqué sous forme de couches ou massivement par croissance en phase vapeur selon la méthode dite de Lely. Cette méthode procure des cristaux de bonne qualité mais présente l'inconvénient de mettre en oeuvre des températures très élevées (supérieures à 2000°C).

Un autre procédé a été proposé permettant la mise en oeuvre d'une température moins élevée. Ce procédé est décrit dans l'article "Growth of Silicon Carbide from Liquid Silicon by a Travelling Heater Method" de K. GILLESSEN et W. von MUNCH, paru dans Journal of Crystal Growth, 19 (1973), pages 263-268. Il est proposé de créer par chauffage inductif une zone solvante liquide, en l'occurrence du silicium, entre deux barreaux de carbure de silicium polycristallin placés en alignement vertical. L'obtention d'une zone flottante de silicium par induction est une technique parfaitement maîtrisée par l'homme de l'art. Les conditions de croissance sont telles que le procédé est mis en oeuvre dans une ampoule de quartz fermée. En effet, une température de 1800°C est imposée en haut de la zone liquide et pour pallier à l'évaporation consécutive importante du silicium, un ajout d'iode est prévu. La réaction de transport se produisant entre l'iode et le silicium en phase gazeuse impose de travailler en système fermé.

Un déplacement lent et vers le haut de l'ampoule provoque une distribution asymétrique de la température à l'intérieur de la zone liquide, ce qui amorce le transport du carbure de silicium depuis le barreau inférieur vers le barreau supérieur où l'on obtient un cristal massif.

Ce procédé présente un certain nombre d'inconvénients qui peuvent être regroupés de la manière suivante : les contraintes liées à la croissance en ampoule, les problèmes consécutifs à l'ajout d'iode et ceux provenant de la température relativement élevée.

L'ampoule demande une préparation préliminaire. Il faut y intégrer tous les composants avec la difficulté d'aligner correctement les deux barreaux, la réalisation du dégazage et du scellage. Il faut tenir compte de l'encombrement de l'ampoule : pour un diamètre de bobine d'induction donné, la dimension des cristaux obtenus est forcément inférieure à celle à laquelle on pourrait s'attendre en l'absence d'ampoule. De plus, une distance optimale charge-paroi de l'ampoule doit être trouvée et respectée. Il est nécessaire aussi de travailler avec des composés très purs pour éviter le dépôt d'impuretés sur la paroi de l'ampoule. La présence d'une ampoule implique des phénomènes thermiques plus compliqués et donc un contrôle de la température plus difficile.

L'ajout d'iode apporte aussi ses problèmes. Pour éviter la condensation de l'iode sur la paroi de l'ampoule, celle-ci doit être maintenue à une température suffisamment élevée (température de la partie la plus froide : 700°C). L'utilisation d'un second système de chauffage, en plus de la bobine d'induction, rend donc le montage plus complexe. En outre, l'insertion possible d'iode dans les cristaux obtenus peut être néfaste pour les applications ultérieures de ces cristaux.

D'autre part, les cristaux de SiC du polytype 3C s'obtiennent plus aisément à plus basse température car ils sont plus stables. Ceci est une limitation importante du procédé.

### Exposé de l'invention

Il est proposé, selon la présente invention, de réaliser la croissance du matériau à obtenir à une température suffisamment basse pour que le phénomène d'évaporation devienne négligeable. Dans le cas de l'élaboration de cristaux de carbure de silicium, l'ajout d'iode et la présence d'une ampoule deviennent inutiles.

L'invention a donc pour objet un procédé d'obtention d'un cristal d'un matériau ayant une fusion non congruente et constitué à partir d'au moins un premier élément et un deuxième élément, le procédé comprenant les étapes suivantes :
- mise en place en alignement vertical, et maintien sous atmosphère neutre ou sous vide, d'un barreau de premier élément enserré entre un barreau inférieur et un barreau supérieur constitués dudit matériau,
- transformation du barreau de premier élément en zone flottante par chauffage à une température évitant l'évaporation du premier élément, le chauffage étant obtenu par des moyens de chauffage réalisant un gradient de température dans la zone flottante tel que l'une des faces de l'un d'entre le barreau inférieur et le barreau supérieur qui est en contact avec le barreau de premier élément apparaît comme un côté froid,
- mise en contrarotation des barreaux inférieur et supérieur autour de l'axe d'alignement et déplacement relatif, le long de l'axe d'alignement, de l'ensemble des barreaux par rapport aux moyens de chauffage pour en éloigneer le côté froid et pour obtenir sur le côté froid, par croissance en solution, ledit cristal.

Les barreaux mis en place peuvent être maintenus sous atmosphère d'argon.

Le chauffage peut être obtenu par induction produite par exemple par une bobine plate entourant le barreau de premier élément. Il peut aussi être obtenu au moyen d'un four à miroir.

La croissance dudit cristal peut se faire à partir d'un germe disposé sur la face inférieure du barreau supérieur ou sur la face supérieure du barreau inférieur.

Le procédé s'applique avantageusement à l'obtention d'un cristal de carbure de silicium, le barreau de premier élément étant en silicium, les barreaux inférieur et supérieur étant en carbure de silicium polycristallin obtenus par exemple par frittage de poudre ou par sublimation. Il permet notamment l'obtention d'un cristal de carbure de silicium du polytype 3C. Il s'applique aussi à l'obtention de nitrure de silicium ou d'un alliage Si-Ge.

L'invention a aussi pour objet un dispositif d'obtention d'un cristal d'un matériau ayant une fusion non congruente et constitué à partir d'au moins un premier élément et un deuxième élément, le dispositif comprenant :
- une enceinte apte à être mise sous atmosphère neutre ou sous vide,
- des moyens permettant de maintenir dans l'enceinte et en alignement vertical un ensemble comprenant un barreau de premier élément enserré entre un barreau inférieur et un barreau supérieur constitués dudit matériau, lesdits moyens permettant également la mise en contrarotation des barreaux inférieur et supérieur autour de l'axe d'alignement,
- des moyens de chauffage permettant de transformer le barreau de premier élément en zone flottante par chauffage en réalisant un gradient de température dans la zone flottante tel que l'une des faces de l'un d'entre le barreau inférieur et le barreau supérieur qui est en contact avec le barreau de premier élément apparaît comme un côté froid,
- des moyens permettant le déplacement relatif, le long de l'axe d'alignement, de l'ensemble des barreaux par rapport aux moyens de chauffage pour en éloigner le côté froid.

L'atmosphère neutre de l'enceinte peut être une atmosphère d'argon.

Les moyens de chauffage peuvent être des moyens de chauffage par induction. Ils peuvent comprendre par exemple une bobine plate entourant ledit barreau de premier élément. Ils peuvent aussi être constitués d'un four à miroir.

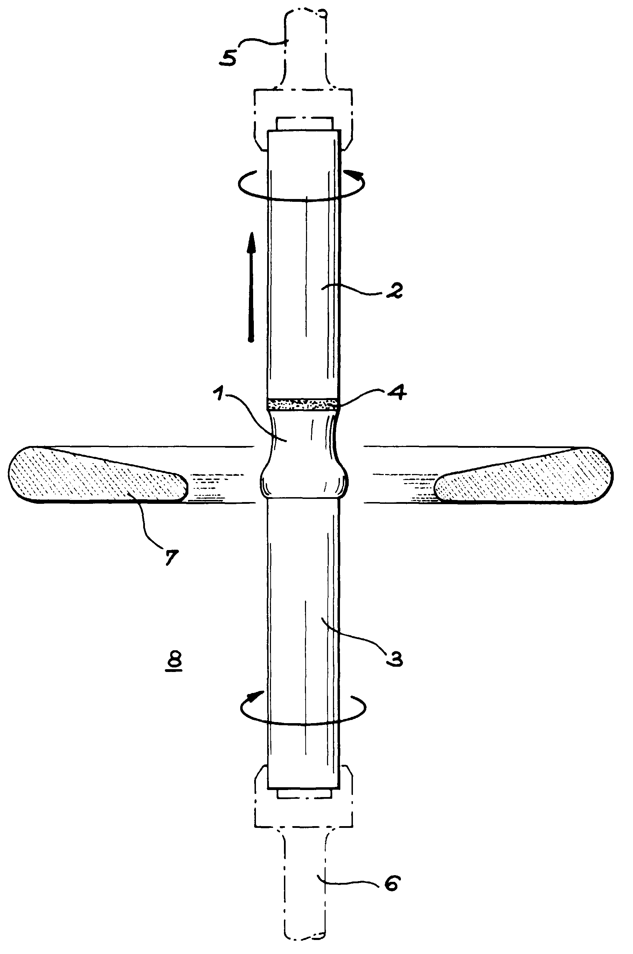

### Brève description du dessin

L'invention sera mieux comprise et d'autres avantages et particularités apparaîtront à la lecture de la description qui va suivre, donnée à titre d'exemple non limitatif, accompagnée du dessin annexé qui illustre l'obtention d'un cristal par croissance en solution dans une zone flottante, selon l'invention.

### Description détaillée d'un mode de réalisation de l'invention

La figure annexée montre, en alignement vertical, un barreau de silicium non dopé 1 maintenu entre deux barreaux de carbure de silicium polycristallin : un barreau supérieur 2 et un barreau inférieur 3. Le cristal désiré devant croître sur le barreau supérieur 2, il est préférable de fixer un germe de SiC 4 sur l'extrémité inférieure du barreau supérieur 2. Le procédé se déroule dans une enceinte fermée, non représentée, sous atmosphère d'argon 8.

Une bobine d'induction 7 permet de faire fondre le silicium du barreau 1 qui devient alors solvant du SiC. La bobine d'induction 7 est centrée sur l'axe de l'alignement vertical et est positionnée de façon à réaliser un gradient de température dans la zone flottante constituée par la matière fondue du barreau 1, la face inférieure du barreau supérieur 2 apparaissant comme un côté froid.

Le barreau supérieur 2 est maintenu et mis en rotation sur lui-même et autour de l'axe vertical d'alignement par un organe approprié 5. Le barreau inférieur 3 est maintenu et mis en rotation sur lui-même et autour de l'axe vertical d'alignement par un organe approprié 6, la rotation se faisant en sens inverse par rapport à la rotation de l'organe 5. En fonctionnement, les organes 5 et 6 imposent à l'ensemble des barreaux un mouvement de translation ascendant.

La rotation en sens opposé des barreaux supérieur 2 et inférieur 3 permet d'une part d'homogénéiser la matière fondue et d'autre part d'accélérer, dans cette matière fondue, le transport du SiC et/ou du carbone. Ainsi, malgré une température de croissance relativement faible (suffisamment basse pour que l'évaporation du silicium devienne négligeable) et donc une solubilité du carbone dans le silicium faible, des vitesses de croissance raisonnables peuvent être atteintes.

A titre d'exemple, les barreaux supérieur 2 et inférieur 3 peuvent être en SiC polycristallin obtenus par frittage de poudre. Leur diamètre peut être de 10 mm. La hauteur de la zone fondue de silicium peut être de l'ordre de 7 mm. La bobine d'induction 7 est une bobine plate du type "pancake", de 22 mm de diamètre intérieur. Elle est alimentée par un courant alternatif de 3 MHz. La pression d'argon dans l'enceinte de travail est la pression atmosphérique normale.

La vitesse de rotation des barreaux supérieur et inférieur peut être de 20 tours/minute et la translation de l'ensemble des barreaux peut se faire à une vitesse de 0,1 mm/heure. Le gradient de température au voisinage de l'interface de croissance est inférieur à 100 K/mm, typiquement quelques dizaines, par exemple 15 K/mm.

De cette manière on peut obtenir, avec un dispositif beaucoup plus simple que celui de l'art antérieur, la croissance effective de carbure de silicium du polytype 3C ce qui est un avantage appréciable. En effet, parmi les polytypes les plus courants de carbure de silicium, le polytype 3C présente la plus grande mobilité électronique, ce qui élargit encore le champ de ses applications.

Il est possible d'appliquer ce procédé à la croissance de cristaux d'autres matériaux ayant une fusion non congruente tels que le nitrure de silicium Si₃N₄ ou des alliages comme par exemple Si-Ge.

## Revendications

1. Procédé d'obtention d'un cristal d'un matériau ayant une fusion non congruente et constitué à partir d'au moins un premier élément et un deuxième élément, le procédé comprenant les étapes suivantes :
- mise en place en alignement vertical, et maintien sous atmosphère neutre ou sous vide, d'un barreau de premier élément (1) enserré entre un barreau inférieur (3) et un barreau supérieur (2) constitués dudit matériau,
- transformation du barreau de premier élément (1) en zone flottante par chauffage à une température évitant l'évaporation du premier élément, le chauffage étant obtenu par des moyens de chauffage (7) réalisant un gradient de température dans la zone flottante tel que l'une des faces de l'un d'entre le barreau inférieur (3) et le barreau supérieur (2) qui est en contact avec le barreau de premier élément (1) apparaît comme un côté froid,
- mise en contrarotation des barreaux inférieur (3) et supérieur (2) autour de l'axe d'alignement et déplacement relatif, le long de l'axe d'alignement, de l'ensemble des barreaux (1,2,3) par rapport aux moyens de chauffage pour en éloigner le côté froid et pour obtenir sur le côté froid, par croissance en solution, ledit cristal.

2. Procédé selon la revendication 1, caractérisé en ce que lesdits barreaux (1,2,3) mis en place sont maintenus sous atmosphère d'argon.

3. Procédé selon l'une des revendications 1 ou 2, caractérisé en ce que le chauffage est obtenu par induction.

4. Procédé selon la revendication 3, caractérisé en ce que le chauffage est obtenu par l'induction produite par une bobine plate (7) entourant ledit barreau de premier élément (1).

5. Procédé selon l'une des revendications 1 ou 2, caractérisé en ce que le chauffage est obtenu au moyen d'un four à miroir.

6. Procédé selon l'une quelconque des revendications 1 à 5, caractérisé en ce que la croissance dudit cristal se fait à partir d'un germe (4) disposé sur la face inférieure du barreau supérieur (2).

7. Procédé selon l'une quelconque des revendications 1 à 5, caractérisé en ce que la croissance dudit cristal se fait à partir d'un germe disposé sur la face supérieure du barreau inférieur.

8. Application du procédé selon l'une quelconque des revendications 1 à 7 à l'obtention d'un cristal de carbure de silicium, le barreau de premier élément (1) étant en silicium, les barreaux inférieur (3) et supérieur (2) étant en carbure de silicium polycristallin.

9. Application selon la revendication 8, caractérisée en ce que les barreaux inférieur (3) et supérieur (2) en carbure de silicium polycristallin sont obtenus par frittage de poudre.

10. Application selon la revendication 8, caractérisée en ce que les barreaux inférieur et supérieur en carbure et silicium polycristallin sont obtenus par sublimation.

11. Application selon l'une quelconque des revendications 8 à 10 à l'obtention d'un cristal de carbure de silicium du polytype 3C.

12. Application du procédé selon l'une quelconque des revendications 1 à 7 à l'obtention de nitrure de silicium.

13. Application du procédé selon l'une quelconque des revendications 1 à 7 à l'obtention d'un alliage Si-Ge.

14. Dispositif d'obtention d'un cristal d'un matériau ayant une fusion non congruente et constitué à partir d'au moins un premier élément et un deuxième élément, le dispositif comprenant :
- une enceinte apte à être mise sous atmosphère neutre (8) ou sous vide,
- des moyens (5,6) permettant de maintenir dans l'enceinte et en alignement vertical un ensemble comprenant un barreau de premier élément (1) enserré entre un barreau inférieur (3) et un barreau supérieur (2) constitués dudit matériau, lesdits moyens permettant également la mise en contrarotation des barreaux inférieur (3) et supérieur (2) autour de l'axe d'alignement,
- des moyens de chauffage (7) permettant de transformer le barreau de premier élément (1) en zone flottante par chauffage en réalisant un gradient de température dans la zone flottante tel que l'une des faces de l'un d'entre le barreau inférieur (3) et le barreau supérieur (2) qui est en contact avec le barreau de premier élément (1) apparaît comme un coté froid,
- des moyens permettant le déplacement relatif, le long de l'axe d'alignement, de l'ensemble des barreaux (1,2,3) par rapport aux moyens de chauffage (7) pour en éloigner le côté froid.

15. Dispositif selon la revendication 14, caractérisé en ce que ladite atmosphère neutre de l'enceinte est une atmosphère d'argon.

16. Dispositif selon l'une des revendications 14 ou 15, caractérisé en ce que les moyens de chauffage (7) sont des moyens de chauffage par induction.

17. Dispositif selon la revendication 16, caractérisé en ce que les moyens de chauffage par induction comprennent une bobine plate (7) entourant ledit barreau de premier élément.

18. Dispositif selon l'une des revendications 14 ou 15, caractérisé en ce que les moyens de chauffage sont constitués d'un four à miroir.
